# EUROPÄISCHE PATENTSCHRIFT

(11) **EP 2 031 667 B1**
(45) Veröffentlichungstag und Bekanntmachung des Hinweises auf die Patenterteilung: **16.01.2019**
(21) Anmeldenummer: 08162093.2
(22) Anmeldetag: 08.08.2008
(51) Int. Cl.: H01L 33/00, H01L 33/48, H01L 33/58, H01L 25/075

(54) **Leuchtdioden-Gehäuse**
Light emitting diode housing
Boîtier de diode électroluminescent

(30) Priorität: 30.08.2007 DE 102007041133
(43) Veröffentlichungstag der Anmeldung: 04.03.2009
(73) Patentinhaber: OSRAM Opto Semiconductors GmbH, 93055 Regensburg (DE)
(72) Erfinder: Engl, Moritz, 93055, Regensburg (DE); Oswald, Florin, 6240, Rattenberg (AT)
(74) Vertreter: Epping - Hermann - Fischer

(56) Entgegenhaltungen:
- EP-A1- 1 691 425
- JP-A- 2000 183 405
- JP-A- 2002 223 005
- JP-A- 2004 349 646
- JP-A- 2007 201 945
- US-A1- 2006 006 791
- US-A1- 2007 075 306

## Beschreibung

Die Erfindung betrifft ein Gehäuse für ein optoelektronisches Bauelement, welches in seinem Betrieb eine elektromagnetische Strahlung emittiert, wobei verhindert wird, dass das Gehäuse seitlich Strahlung aussendet. Zusätzlich wird ein Verfahren zur Aussendung elektromagnetischer Strahlung in einer Vorzugsrichtung beschrieben.

Elektromagnetische Strahlung aussendende optoelektronische Bauelemente finden heutzutage ein sehr großes Anwendungsgebiet. Für die jeweilige Anwendung ist ein solches optoelektronisches Bauelement vielfältig in Farb-, Leistungs- und Montageart ausgestaltet. Demzufolge ist es sinnvoll, für jedes optoelektronische Bauelement eine für die Anwendung spezifische Gehäuseform, Gehäuseart und/oder Gehäusemontage vorzusehen. Insbesondere werden hier LED (Light Emitting Diode), auch bekannt als Leuchtdiode oder Lumineszenzdiode, als elektromagnetische Strahlung aussendende optoelektronische Bauelemente angesehen.

LEDs finden immer häufiger Anwendung in Scheinwerfer oder Projektionsapplikationen. Ein Beispiel für einen Scheinwerfer, in dem elektromagnetische Strahlung emittierende Lumineszenzdioden verwendet werden, ist in der DE 1031 5131 A1 angegeben. Hierbei handelt es sich um einen Scheinwerfer für Kraftfahrzeuge, bei dem eine Mehrzahl von Halbleiterchips in einer gemeinsamen Gehäusekavität angeordnet sind.

Die Erzeugung des Weißlichtes für eine Scheinwerferapplikation wird beispielsweise durch Chiplevelkonversion erreicht. Hierzu wird eine dünne Schicht eines Konversionsmaterials bereits im Halbleiterchipherstellungsprozess auf den Chip aufgebracht und somit ein Weißlichtchip hergestellt.

Bei solchen Scheinwerferapplikationen wird angestrebt, eine von dem Halbleiterchip beziehungsweise den Halbleiterchips emittierten elektromagnetischen Strahlung mit einer möglichst hohen Strahlungsdichte in einen vorgegebenen, engen Raumwinkel abzustrahlen. Da der Einfluss dieser Scheinwerferapplikationen speziell im Kraftfahrzeugbereich immer stärker Einzug hält, werden bereits heutzutage Kfz-Scheinwerfer, speziell das Abblendlicht, mittels LEDs realisiert. Hierbei ist für den LED-Hersteller zu beachten, dass das Licht einen gewünschten Abstrahlwinkel nicht überschreitet, beziehungsweise die Lichtintensität außerhalb des bevorzugten Abstrahlwinkels durch beispielsweise spezielle Vorrichtungen stark bedämpft wird. Hintergrund ist die im Straßenverkehr geforderte spezielle Abstrahlcharakteristik von Scheinwerfern, um sicherzustellen, dass insbesondere entgegenkommende Fahrzeuge nicht durch die Scheinwerferanordnung geblendet werden. Dazu werden heutzutage beispielsweise Strahlenkegel mittels Optiken wie Projektionslinsen auf eine gewünschte Ebene projiziert.

Nachteilig ist hierbei, dass bei derartigen Anwendungen Unregelmäßigkeiten in der Abstrahlcharakteristik verwendeter LED verstärkt werden können und somit besonders störend sind. Diesbezüglich gibt es einen Bedarf an Bauelementen, die hinsichtlich ihrer Abstrahleigenschaften speziell für derartige Anwendungen ausgebildet sind. Aus der Patentanmeldung DE 10 2005 059524 A1 ist eine Gehäuseanordnung bekannt, wobei ein Gehäusegrundkörper mit einer Ausnehmung auf mindestens einer Chipmontagefläche angeordnet ist. Zumindest eine Außenfläche des Grundkörpers die auf der Abstrahlseite des Gehäuses angeordnet ist und in die Ausnehmung angrenzt, ist mit einer Abschirmschicht versehen, die geeignet ist, eine elektromagnetische Strahlung abzuschirmen.

Die Druckschrift US 2007/075306 A1 beschreibt ein lichtemittierendes Bauteil mit einem LED Chip, einem Gehäuse und einem optischen Element. Von dem LED Chip emittiertes Licht tritt durch eine Öffnung aus dem Gehäuse aus und wird durch das optische Element nach außen hin abgestrahlt. Ein Flansch des Gehäuses dient dabei einer Positionierung des optischen Elements. Eine schwarze Abdeckung ist auf einer Oberfläche des Gehäuses angeordnet, um eine visuelle Wahrnehmung eines An bzw. Auszustands des LED Chips in Strahlungsrichtung zu verbessern.

Die Druckschrift US 2006/006791 A1 beschreibt eine Anzeige mit einer LED sowie einem opaken Substrat, das ein Loch aufweist, welches durch ein transparentes Fenster 42 bedeckt ist. Das Substrat kann TiO2 aufweisen, so dass Licht, welches in das Substrat eintritt, absorbiert wird.

Die Druckschrift JP 2002 223005 A beschreibt eine LED, bei der ein lichtemittierendes Element in einer von schwarzem Epoxidharz umgebenen Spiegelausnehmung angeordnet und durch eine elliptisch geformte konvexe Linse aus transparentem Epoxidharz verkapselt ist.

Die Druckschrift JP 2007 201945 A beschreibt ein Halbleiterbauteil mit einem optischen Element, das angeordnet ist zwischen einem Paar Trägerelementen, umfassend jeweils einen Leiter, und von einem lichtdurchlässigen Element bedeckt ist. Das lichtdurchlässige Element ist über ein Klebemittel mit den Trägerelementen verbunden, wobei das Klebemittel Lichtreflexionen des Leiters unterdrücken kann.

Die Druckschrift EP 1 691 425 A1 beschreibt ein lichtemittierendes Bauelement mit einem LED Chip, der in einer Ausnehmung eines Substrats angeordnet ist und von einer Lichtwellenwandlungseinheit bedeckt. Ein Rahmen aus lichtundurchlässigem Material ist auf einer Lichtaustrittsfläche der Lichtwellenwandlungseinheit angeordnet, so dass Licht, das aus einem Randbereich der Lichtwellenwandlungseinheit austritt blockiert wird.

Die Druckschrift JP 2000 183405 A beschreibt ein Lichtemittierendes Bauelement mit einem lichtemittierenden Element, das in einer Ausnehmung eines Gehäuses angeordnet ist. Die Ausnehmung ist mit einem Vergussmaterial befüllt. An einem Randbereich des Gehäuses ist eine lichtabsorbierende Schicht angeordnet, die durch das Vergussmaterial durchdrungen wird.

Ein weiterer Nachteil des bekannten Stands der Technik ist, dass eine Abdeckung zum Schutz der Halbleiterchips sowie der Bondverdrahtung innerhalb der Gehäusekavität mit dem Gehäuseunterteil durch ein klebendes Material verbunden ist. Dieses klebende Material weist in den Randbereichen des Gehäuseunterteils durch den Herstellungsprozess einen Wulst auf. Durch diesen Wulst wird Licht in die Abdeckung optisch eingekoppelt und tritt erst an den Seitenflächen der Abdeckung wieder aus. Die Abdeckung funktioniert quasi als Lichtwellenleiter. Dadurch, dass die Abdeckung nicht planar abgeschliffen ist, kommt es an den Seitenflächen der Abdeckung zu Brechungen des eingekoppelten Lichtes in alle möglichen Richtungen und daraufhin zum unerwünschten Ausstrahlen von Licht auch außerhalb einer bevorzugten Ausstrahlrichtung.

Die Aufgabe der hier vorliegenden Erfindung besteht nun darin, ein Gehäuse für ein optoelektronisches Bauelement, welches elektromagnetische Strahlung aussendet, aufzuzeigen, bei dem durch technisch einfache Maßnahmen die Abstrahlcharakteristik gegenüber bekannten Gehäusen verbessert ist und Licht, welches orthogonal zur Hauptausstrahlrichtung ausgesendet wird, bedämpft oder absorbiert ist. Beispielsweise kann diese Licht maximal bedämpft oder absorbiert werden. Das heißt, dass in diesem Fall möglichst gar kein Licht mehr orthogonal zur Hauptausstrahlrichtung ausgesendet wird.

Mit anderen Worten soll störendes Streulicht durch Maßnahmen bei der Gehäusegestaltung hinreichend unterdrückt werden. Das Gehäuse sollte insbesondere besser für Scheinwerferapplikationen und/oder Projektionsapplikationen geeignet sein.

Das Gehäuse umfasst ein Gehäuseunterteil, wobei das Gehäuseunterteil eine Gehäusekavität aufweist. Diese Gehäusekavität weist eine Öffnung zu einer Seite des Gehäuses der LED auf, wodurch die Kavität auch als Ausnehmung bezeichnet wird. Der Boden der Gehäusekavität ist für eine Montage eines Lumineszenzdiodenchips, hier folgend als Halbleiterchip bezeichnet, vorgesehen. Die Innenwände der Kavität können in der Art eines Reflektors geformt sein, sodass ein Teil einer von dem Halbleiterchip emittierten elektromagnetischen Strahlung mittels dieser reflektierenden Innenwände in einen gewünschten Abstrahlraumwinkel umgelenkt wird.
Es wird ein Gehäuse mit einem Gehäuseunterteil, einer Gehäusekavität innerhalb des Gehäuseunterteils mit einer an einer Gehäuseseite ausgebildeten Öffnung mindestens einem eine elektromagnetische Strahlung aussendenden Halbleiterchip welcher in der Gehäusekavität angeordnet ist und einer für die Strahlung zumindest teilweise transparenten Abdeckung, die die Gehäusekavität abdeckt, angegeben. Hierbei ist die Abdeckung derart mit dem Gehäuseunterteil verbunden, dass die elektromagnetische Strahlung, die aus den Seitenflächen der Abdeckung austritt, absorbiert wird. Zudem ist weiterhin ein Verfahren angegeben, bei dem Licht von einem elektromagnetischen Bauelement in einer Vorzugsrichtung abgestrahlt wird. Beispielsweise wird die elektromagnetische Strahlung vom Gehäuseunterteil absorbiert.
Durch dieses Gehäuse und diesem Verfahren wird in vorteilhafter Weise ein Austritt elektromagnetischer Strahlung aus dem Gehäuse in unerwünschte Raumwinkel deutlich verringert beziehungsweise im Idealfall vollständig vermieden.
Das Gehäuse weist ein Absorptionsmaterial auf, was wiederum derart platziert ist, dass das Absorptionsmaterial die zu den Seitenflächen der Abdeckung austretende Strahlung absorbiert. Durch Einbringen des Absorptionsmateriales, zwischen den Seitenflächen der Abdeckung und dem Gehäuseunterteil wird speziell das in die Abdeckung eingekoppelte Licht absorbiert. Somit wird verhindert, dass Licht außerhalb eines unerwünschten Abstrahlwinkels ausgesendet wird.

Das Gehäuseunterteil ist mehrteilig ausgebildet, wobei eine Gehäusebasis verbunden ist mit einem Gehäuserahmen. Dieser Rahmen weist eine Rahmenausnehmung auf, in die die Abdeckung platziert ist. Durch diese Maßnahme wird Licht, welches an den Seitenflächen der Abdeckung austritt, bereits durch den Gehäuserahmen absorbiert.

Insbesondere durch ein absorbierendes Klebemittel, welches die Verbindung zwischen der Abdeckung und dem Gehäuserahmen herstellt, ist bereits ein Eintreten des Lichtes in die Abdeckung durch den zu Beginn beschriebenen Wulst unterbunden und stellt somit eine vorteilhafte Ausgestaltung dar.

In einer vorteilhaften Ausführung ist die Höhe der Abdeckung gleich oder kleiner als die Höhe der Rahmenausnehmung. Dadurch wird erreicht, dass das komplett aus den Seitenflächen austretende Licht in den Gehäuserahmen eingekoppelt und durch geeignetes Gehäusematerial absorbiert wird. Diese Maßnahme stellt einen sehr effektiven Schutz zur Verringerung von Licht außerhalb des gewünschten Strahlkegels dar.

Durch Beschichten der Seitenfläche mit einem absorbierenden Material (Schicht) wird der Austritt der in die Abdeckung eingekoppelten Strahlung verhindert. Durch diese vorteilhafte Ausgestaltung tritt kein Licht aus den Seitenflächen der Abdeckung aus, wodurch wiederum eine Abstrahlung in unerwünschte Richtungen unterbunden wird.

Die Abdeckung ist auf der der Gehäusekavität entgegengesetzten Oberseite im Randbereich mit einer absorbierenden Schicht beschichtet. Da die Abdeckung und speziell die Seitenflächen der Abdeckung nicht planar ausgestaltet sind, kommt es an den Seitenflächen zu einem Austritt des Lichtes in alle erdenklichen Raumwinkel. Das Gehäuseunterteil absorbiert im Idealfall alles einfallende Licht. In einem Extremfall wird das Licht möglicherweise vom Gehäuseunterteil reflektiert. Durch diese Ausgestaltung wird der Bereich, in dem Licht in den freien Raum gesendet wird, weiter verkleinert. Dadurch wird reflektiertes Licht nicht außerhalb eines bestimmten Abstrahlbereiches auftreten.

In einer vorteilhaften Weise ist die absorbierende Schicht auf der Oberseite der Abdeckung das Absorptionsmaterial. Dadurch wird ein Herstellungsschritt und auch ein Herstellungsmaterial eingespart und der Herstellungsprozess deutlich vereinfacht.

In einer weiteren vorteilhaften Ausgestaltung sind die Seitenflächen der Abdeckung mit einer absorbierenden Schicht beschichtet. Zusätzlich zur Platzierung der Abdeckung in dem Gehäuserahmen und dem Absorptionsmaterial zwischen Rahmen und Abdeckung weist diese absorbierende Schicht eine zusätzliche verbesserte Variante zur Verminderung des zur Seitenfläche der Abdeckung austretenden Lichtes auf.

In einer vorteilhaften Ausgestaltung ist das Gehäuseunterteil ein Keramikmaterial. Durch Wahl dieses Materials ist eine erhöhte thermische Resistenz und Strahlresistenz gegenüber der ausgestrahlten elektromagnetischen Strahlung, insbesondere Ultraviolettbereich, gegeben. In einer Weiterführung kann das Material des Gehäuseunterteils auch ein Kunststoffmaterial sein, wodurch durch einfache Spritz- und Vergusstechniken die Gehäuseform herstellbar ist. Dies stellt einen vereinfachten Herstellungsprozess und somit verringerte Herstellungskosten dar.

In einer weiteren vorteilhaften Ausgestaltung ist das Material der Abdeckung ein Glasmaterial und/oder ein ausgehärtetes Silikonmaterial. Somit wird speziell bei Scheinwerferapplikationen zusätzlich zur zumindest teilweisen Transparenz der Abdeckung für die aussendende elektromagnetische Strahlung weiterhin eine genügende thermische Resistenz der Abdeckung erreicht. Zusätzlich dient eine solche Abdeckung als Schutz der Halbleiterchips und der Wirebondverbindungen innerhalb der Gehäusekavität.

In einer weiteren vorteilhaften Ausgestaltung ist die Gehäusebasis aus Aluminiumnitrid hingegen der Gehäuserahmen aus Aluminiumoxid. Durch Verwendung dieser Materialien wird eine hohe thermische Wärmeableitung erreicht. Durch Verwendung unterschiedlicher Materialien wird die Gehäusewärmeabfuhr optimal an den bestimmten Bereichen des Gehäuses angepasst, wobei die Gehäusebasis einen höheren Wärmeableitkoeffizienten aufweisen sollte, da hier die Halbleiterchips montiert sind.

In einer weiteren vorteilhaften Ausgestaltung besteht sowohl die Gehäusebasis als auch der Gehäuserahmen aus demselben Material. Im Idealfall sind Gehäusebasis und Gehäuserahmen ein Gehäuseteil, wodurch eine vereinfachte Herstellung, beispielsweise als Spritzgusstechnik, ermöglicht ist. Als Material ist, insbesondere bei thermisch unkritischen Applikationen, ein Kunststoffmaterial denkbar. Hierdurch werden die Fertigungskosten minimiert.

Des Weiteren weist die Beschreibung ein Verfahren zur Aussendung elektromagnetischer Strahlung in einer Vorzugsrichtung mittels einem eine Strahlung aus dem Halbleiterbauelement mit folgenden Schritten auf:
Zunächst wird ein Halbleiterchip in einer Seite des Gehäuses geöffneten Gehäusekavität innerhalb eines Gehäuseunterteils des Halbleiterbauelements platziert. In einem weiteren Schritt wird das Gehäuseunterteil mittels eines zumindest teilweise transparenten Abdeckmaterials abgedeckt. In einem dritten Herstellungsschritt wird das Gehäuseunterteil mit der Abdeckung derart verbunden, dass seitlich aus der Abdeckung austretende Strahlung absorbiert wird.
Gemäß zumindest einer Ausführungsform des hier beschriebenen Verfahrens, weist das Verfahren also die folgenden Schritte, in der folgenden Reihenfolge auf:
a) Platzieren zumindest eines Halbleiterchips in einer, zu einer Seite des Gehäuses geöffneten Gehäusekavität innerhalb eines Gehäuseunterteils des Halbleiterbauelementes
b) Abdecken des Gehäuseunterteils mittels zumindest teilweiser transparenter Abdeckung,
c) Verbinden der Abdeckung mit dem Gehäuseunterteil derart, dass seitlich aus der Abdeckung austretende Strahlung absorbiert wird.

Gemäß zumindest einer Ausführungsform des hier beschriebenen Verfahrens wird zusätzlich ein Absorptionsmaterial zwischen den Seitenflächen der Abdeckung und des Gehäuseunterteils platziert.

Gemäß zumindest einer Ausführungsform des hier beschriebenen Verfahrens wird das Gehäuseunterteil mehrteilig aufgebaut und weist zumindest einen Gehäuserahmen auf und die Abdeckung wird in den Gehäuserahmen eingepasst.

Gemäß zumindest einer Ausführungsform des hier beschriebenen Verfahrens werden die Seitenflächen winklig abgeschliffen. Gemäß zumindest einer Ausführungsform des hier beschriebenen Verfahrens wird das Absorptionsmaterial teilweise auf der der Gehäusekavität gegenüberliegenden Oberseite der Abdeckung aufgebracht.

Gemäß zumindest einer Ausführungsform des hier beschriebenen Verfahrens wird als Gehäuseunterteilmaterial Aluminiumnitrid und/oder Aluminiumoxid verwendet.

Gemäß zumindest einer Ausführungsform des hier beschriebenen Verfahrens wird als Abdeckungsmaterial Glas oder hitzebeständiges Silikon verwendet.

Nachfolgend wird die Erfindung anhand von Ausführungsbeispielen mit Bezug auf die Zeichnung erläutert, wobei die Figuren gleicher oder gleich wirkender Bestandteile jeweils mit den gleichen Bezugszeichen gekennzeichnet sind. Die dargestellten Elemente sind nicht als maßstabsgerecht anzusehen, vielmehr können einzelne Elemente zum besseren Verständnis übertrieben groß, beziehungsweise übertrieben vereinfacht dargestellt sein.
Im Folgenden sind Ausführungsformen, die als "Beispiel" gekennzeichnet sind, nicht Teil der Erfindung und dienen lediglich zum besseren Verständnis. Nur Ausführungsformen, die als "Ausführungsbeispiel" gekennzeichnet sind, sind Teil der Erfindung. Es zeigen:
- Figur 1: ein schematisch dargestelltes Beispiel eines Gehäuses,
- Figur 2: einen Querschnitt einer Weiterbildung des in Figur 1 dargestellten Gehäuses,
- Figur 3: eine alternative Weiterbildung des in Figur 1 dargestellten Gehäuses,
- Figur 4: eine Weiterbildung des in Figur 3 dargestellten Gehäuses,
- Figur 5: eine Weiterbildung des in Figur 3 dargestellten Gehäuses,
- Figur 6: einen Querschnitt einer Weiterbildung des in Figur 5 dargestellten Gehäuses, der ein Ausführungsbeispiel ist,
- Figur 7: ein alternatives Beispiel des in Figur 1 gezeigten Gehäuses gemäß Stand der Technik,
- Figur 8: eine Weiterbildung des in Figur 7 dargestellten Gehäuses,
- Figur 9: einen Querschnitt einer Weiterbildung des in Figur 7 dargestellten Gehäuses und
- Figur 10: einen Querschnitt einer Weiterbildung des in Figur 9 dargestellten Gehäuses.

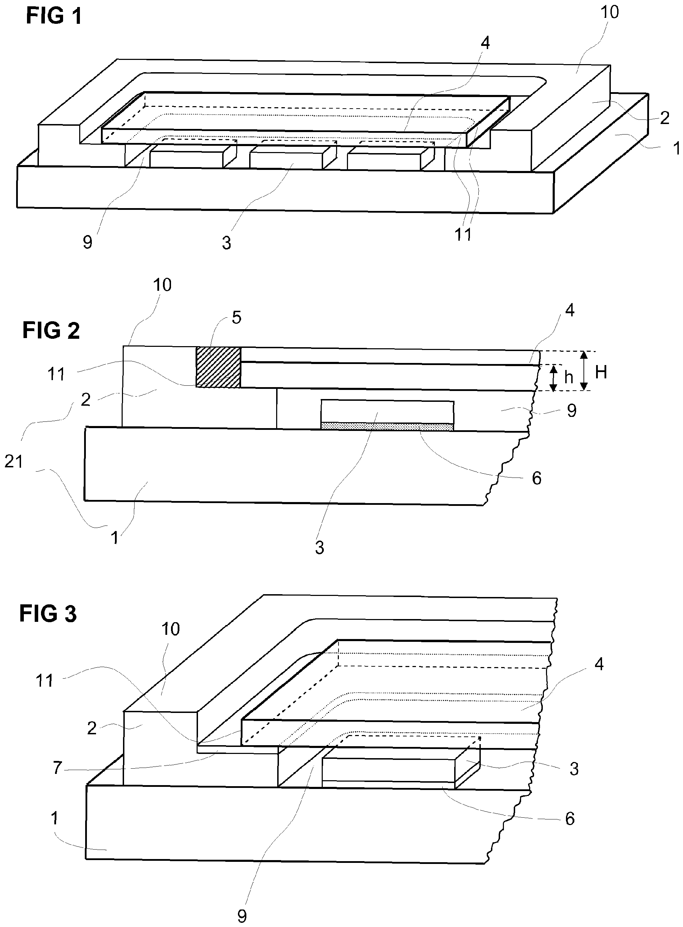

Figur 1 zeigt ein schematisch dargestelltes Beispiel eines Gehäuses. Das Gehäuse weist hierbei eine Gehäusebasis 1 und einen Gehäuserahmen 2 auf. Innerhalb des Gehäuserahmens ist eine Gehäusekavität 9 eingebracht. Die Gehäusekavität 9 weist zu einer Gehäuseseite 10 eine Öffnung auf. Auf der Gehäusebasis 1 innerhalb der Gehäusekavität 9 sind Halbleiterchips 3 angeordnet und mit der Gehäusebasis mechanisch verbunden. Eine Abdeckung 4 ist in den Gehäuserahmen 2 eingebunden. Der Gehäuserahmen 2 weist dazu Gehäuserahmenausnehmungen auf, die die Abdeckung 4 tragen.
Die Halbleiterchips 3 senden im Betrieb elektromagnetische Strahlung aus. Diese elektromagnetische Strahlung wird an den Innenflächen des Gehäuseunterteils 21, welches hier aus Gehäusebasis 1 und Gehäuserahmen 2 besteht, reflektiert und in einer Vorzugsabstrahlrichtung ausgesendet. Dabei tritt das Licht aus der Öffnung der Gehäusekavität der Gehäuseseite 10 aus. Zum Betreiben der Halbleiterchips 3 sind diese beispielsweise mittels Wirebondverfahren elektrisch mit nicht dargestellten Gehäuseanschlüssen verbunden. Zum Schutz der innerhalb der Kavität 9 befindlichen nicht dargestellten Wirebonds wird die Abdeckung 4 in den Hauptstrahlengang der Halbleiterchips 3 eingebracht. Durch beispielsweise Verkleben der Abdeckung mit dem Gehäuseunterteil 21 ist eine mechanische Verbindung der Abdeckung 4 zum Gehäuseunterteil 21, bestehend aus Gehäusebasis 1 und Gehäuserahmen 2, gegeben. Da sich das Klebemittel in den seltensten Fällen derart platzieren lässt, dass kein Wulst am Randbereich der Gehäuserahmenausnehmung innerhalb der Gehäusekavität 9 entsteht, kann Licht durch den Wulst des Klebemittels in die Abdeckung 4 optisch eingekoppelt werden. Die Einkopplung in die Abdeckung 4 führt dazu, dass die Abdeckung 4 zu einem Lichtleiter wird. Das eingekoppelte Licht kann wiederum an den Seitenflächen 11 der Abdeckung 4 austreten. Da die Seitenflächen 11 der Abdeckung 4 im Normalfall nicht planar sind, kommt es bei Austritt aus den Seitenflächen zu einer willkürlichen Aussendung des Lichtes in alle Richtungen. Durch das derartige Einbringen der Abdeckung 4 in das Gehäuseunterteil 21, wird das eingekoppelte Licht durch das Gehäuseunterteil 21 im Idealfall vollständig oder maximal absorbiert. Dazu ist das Gehäusematerial vorzugsweise ein Licht absorbierendes Material.

In der Figur 1 ist das Gehäuseunterteil 21 mehrteilig, bestehend aus Gehäusebasis 1 und Gehäuserahmen 2. Weiterhin denkbar und vom Erfindungsgedanken nicht ausgeschlossen ist ein einteiliges Gehäuseunterteil 21 mit gleicher oder ähnlicher Formgebung. Die dadurch vereinfachte Herstellungsmethode führt zu einer Reduktion der Herstellungskosten. Als Material des Gehäuseunterteils 21 ist vorrangig bei Scheinwerferapplikationen ein thermisch resistentes und gut Wärme leitendes Material zu verwenden, da der Temperaturbereich von -40 bis +150 Grad Celsius betragen kann. Eine Erweiterung des Temperaturbereiches ist hierbei nicht ausgeschlossen. Vorteilhaft für das Gehäuseunterteil 21 ist ein Keramikwerkstoff. Als Material der Gehäusebasis ist Aluminiumnitrid, für den Gehäuserahmen Aluminiumoxid denkbar. Ebenfalls ist ein Kunststoff als Material für das Gehäuseunterteil 21 denkbar.

Die Halbleiterchips 3 sind auch ersetzbar durch einen einzelnen Halbleiterchip. Zur Intensivierung der Lichtstärke sind idealerweise mehrere Halbleiterchips 3 in einem Gehäuse einzubringen.

Die Form des Gehäuses ist nicht auf die dargestellte Form begrenzt, sondern kann je nach Halbleiterchip, Gehäuseunterteil 21, Wärmebedingung beziehungsweise Applikation abweichend sein.

In Figur 2 ist ein Querschnitt einer Weiterbildung des in Figur 1 dargestellten Gehäuses aufgezeigt. Wiederum eine Gehäusebasis 1 trägt einen Gehäuserahmen 2. In einer Ausnehmung des Gehäuserahmens 2 wird eine Abdeckung 4 platziert. Weiterhin ist ein Halbleiterbauelement 3 mittels eines klebenden Materials 6 in die Gehäusekavität 9 eingebracht und auf der Gehäusebasis 1 mechanisch verbindbar. Aufgrund von Fertigungstoleranzen ist ein Spalt zwischen den Seitenflächen 11 der Abdeckung 4 und dem Gehäuserahmen 2 gegeben.

Im Unterschied zu Figur 1 wird durch Ausfüllen dieses Spaltes mit einem Absorptionsmaterial 5 das zur Seitenfläche 11 austretende Licht zusätzlich absorbiert. Diese Absorption kann unterstützend (also zusätzlich) zur Absorption des Gehäuseunterteils 21 wirken und bietet somit eine wirksamere Dämpfung des seitlich austretenden Lichtes. Andererseits ist auch denkbar, dass das Absorptionsmaterial 5 die Absorbiereigenschaft des Gehäuses übernimmt, wodurch ein anderes Gehäusematerial einsetzbar ist.
Wie hier dargestellt ist, ist die Höhe der Abdeckung h kleiner als die Höhe der Rahmenausnehmung H. Durch diese Maßnahme wird gewährleistet, dass das komplett zur Seitenfläche austretende Licht auf den Gehäuserahmen 2 beziehungsweise das Absorptionsmaterial 5 trifft.
Als Absorptionsmaterial 5 ist beispielsweise ein Vergussmaterial, ein Epoxydharz, ein Silikon (auch SiC) oder ein Klebemittel vorteilhaft, wobei ein Klebemittel zusätzlich für eine mechanische Verbindung zwischen Abdeckung 4 und Gehäuseunterteil 21 sorgt. Das Absorptionsmaterial 5 kann darüber hinaus strahlungsabsorbierende Partikel enthalten, die beispielsweise aus Ruß bestehen.
In Figur 3 ist eine alternative Weiterbildung des in Figur 1 dargestellten Gehäuses aufgezeigt. Da die Figur 3 stark der Figur 2 ähnelt, wird hier nur auf die Unterschiede zur Figur 2 eingegangen. Anstelle des in Figur 2 dargestellten Absorptionsmaterials 5 wird hier ein absorbierendes Klebemittel 7 als mechanisches Verbindemittel zwischen Abdeckung 4 und Gehäuserahmen 2 eingebracht. Dieses Klebemittel 7 verhindert das eingangs beschriebene optische Einkoppeln von Licht in die Abdeckung 4. Als absorbierendes Klebemittel 7 ist beispielsweise eingefärbtes Epoxydharz verwendbar.

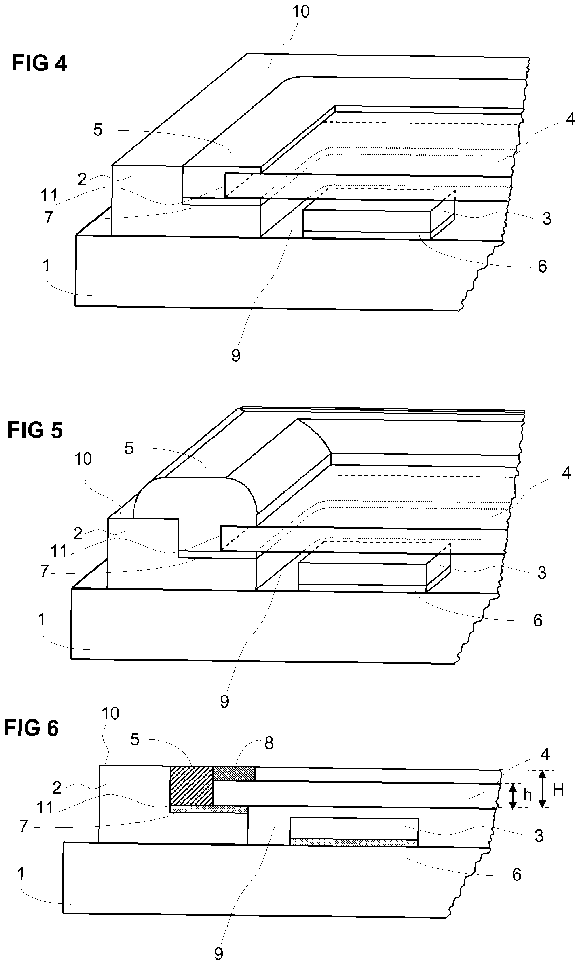

Figur 4 zeigt ein schematisch dargestelltes Beispiel des Gehäuses, das eine Weiterbildung des in Figur 3 dargestellten Gehäuses aufgezeigt. Im Folgenden wird nur auf die Unterschiede zum in Figur 3 aufgezeigten Gehäuse eingegangen. Hierbei ist eine Kombination aus dem absorbierenden Klebemittel 7 und dem Absorptionsmaterial 5 dargestellt, wobei dieses Absorptionsmaterial 5 zusätzlich im Randbereich der Oberseite der Abdeckung 4 eingebracht ist. Dabei ist als Oberseite der Abdeckung 4 die der Gehäusekavität 9 entgegengesetzte Oberseite zu verstehen.

Da das Absorptionsmaterial 5 in den Spalt zwischen der Seitenfläche der Abdeckung 4 und des Gehäuserahmens 2 einzubringen ist, wird es aufgrund der aufgezeigten Abhängigkeit von der Höhe der Abdeckung h und der Rahmenausnehmungshöhe H sehr einfach möglich, das Absorptionsmaterial 5 auch auf den Randbereich der Oberseite der Abdeckung 4 anzubringen. Diese Maßnahme hat zur Folge, dass das an der Seitenfläche reflektierte und in alle Himmelsrichtungen ausgesendete störende Licht zusätzlich im Absorptionsmaterial auf der Oberseite der Abdeckung absorbiert wird. Somit ist kein Licht außerhalb des Strahlkegels der gewünschten Abstrahlcharakteristik des Gehäuses.

Das Absorptionsmaterial auf der Oberseite der Abdeckung 4 wird auch als "glob top" bezeichnet.

In Figur 5 wird eine Weiterbildung des in Figur 3 dargestellten Gehäuses aufgezeigt, wobei im Unterschied zu Figur 4 in Figur 5 das Absorptionsmaterial 5 überhöht auf dem Gehäuserahmen 2 aufgebracht ist und nicht nur Teile der Oberseite der Abdeckung 4, sondern auch Teile der Oberseite 10 des Gehäuserahmens überdeckt. Durch diese Weiterbildung wird ebenfalls Licht, welches an den Seitenflächen der Abdeckung austritt und in alle Richtungen, aufgrund der Rauheit der Seitenflächen 11, reflektiert und nun zusätzlich im Randbereich des Gehäuserahmens 2 absorbiert.
Ebenfalls ist es von Vorteil, dass das Absorptionsmaterial 5 eine bestimmte Mindestdicke aufweist, da bei Unterschreiten einer für die jede Wellenlänge charakteristischen Mindestdicke keine Absorption im Absorptionsmaterial 5 stattfindet.
In Figur 6 ist ein Querschnitt einer Weiterbildung des in Figur 5 dargestellten Gehäuses aufgezeigt, der ein Ausführungsbeispiel ist. Im Unterschied zu Figur 5 ist zusätzlich zum Absorptionsmaterial 5 und der absorbierenden Klebeschicht 7 eine absorbierende Schicht 8 auf den Randbereichen der, der Gehäusekavität 9 entgegengesetzten Oberseite der Abdeckung 4, platziert. Ähnlich wie in Figur 4 und 5 beschrieben dient diese absorbierende Schicht zur Verhinderung eines vergrößerten Abstrahlwinkels und sollte eine Mindestdicke nicht unterschreiten.

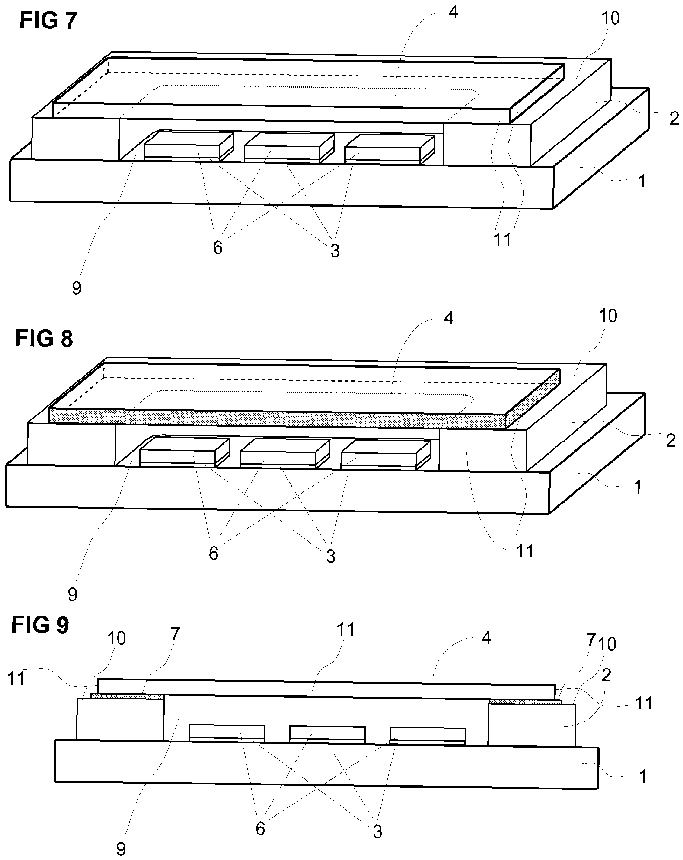

Die Figuren 7 bis 10 zeigen ein alternatives Beispiel des in Figur 1 aufgezeigten Gehäuses. Hierbei ist wiederum eine Gehäusebasis 1 und ein Gehäuserahmen 2 vorgesehen, wobei der Gehäuserahmen 2 anders als in den vorangegangenen Figuren keine Ausnehmung zur Aufnahme der Abdeckung 4 aufweist. Im Gegensatz zu den vorangegangenen Figuren ist die Abdeckung 4 auf dem Gehäuserahmen 2 platziert und mit diesem mechanisch verbunden. Figur 7 stellt hierbei eine Figur gemäß Stand der Technik dar.
In Figur 8 wird eine Weiterbildung des in Figur 7 dargestellten Gehäuses aufgezeigt. Zusätzlich werden hierbei die Seitenflächen 11 der Abdeckung 4 mittels einer absorbierenden Schicht beschichtet. Durch diese Maßnahme wird wiederum verhindert, dass in die Abdeckung eingekoppeltes Licht zu den Seitenflächen 11 der Abdeckung 4 austritt.

Figur 9 zeigt einen Querschnitt einer Weiterbildung des in Figur 7 dargestellten Gehäuses. Hierbei ist ein absorbierendes Klebemittel 7 zwischen Abdeckung 4 und Gehäuseunterteil 21 vorgesehen. Zur Erläuterung dieser Maßnahme wird auf die Figurenbeschreibungen der Figuren 4, 5 und 6 verwiesen.

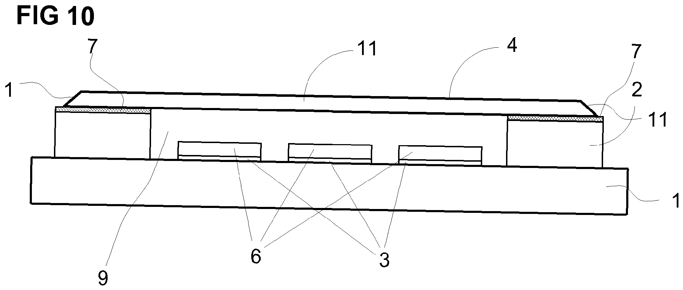

In Figur 10 ist ein Querschnitt einer Weiterbildung des in Figur 9 dargestellten Gehäuses aufgezeigt. Im Unterschied zur Figur 9 sind die Seitenflächen 11 der Abdeckung 4 winklig angeschnitten. Dieser Anschliff ist prinzipiell in zwei Winkeln möglich. In einer ersten und hier nicht aufgezeigten Variante ist der Winkel derart gewählt, dass durch einen zusätzlichen Fertigungsschritt die Seitenflächen 11 mit einer absorbierenden Schicht 8 versehen werden kann, um das zu den Seitenflächen 11 der Abdeckung 4 austretende Licht zu absorbieren. Der Winkel bietet hierbei lediglich einen vereinfachten Aufdampfprozess an.

In einer zweiten, hier dargestellten Variante ist der Winkel derart gewählt, dass das in die Abdeckung 4 eingekoppelte Licht in den Gehäuserahmen 2 beziehungsweise das Gehäuseunterteil 21 abgelenkt wird, wobei es aufgrund der Absorptionseigenschaften des Gehäusematerials absorbiert wird und dementsprechend nicht austritt.

Die in den Figuren 1 bis 10 dargestellten Methoden sind beliebig kombinierbar. Angaben und Beispiele zu Materialien oder Geometrien der Figurenbestandteile gelten grundsätzlich, wenn nicht anders beschrieben, in den anderen Figuren ebenfalls.

Als Abdeckung der Chips wird exemplarisch eine Glasplatte verwendet, da es eine hohe Temperaturstabilität aufweist. Es ist darüber hinaus möglich, andere temperaturstabile transparente Materialien, insbesondere Silizium für Infrarotanwendung oder Siliziumcarbid (SiC) zu verwenden.

## Patentansprüche

1. Gehäuse mit
- einem Gehäuseunterteil (21),
- einer Gehäusekavität (9) innerhalb des Gehäuseunterteils (21)
- einer an einer Gehäuseseite (10) ausgebildeten Öffnung der Gehäusekavität (9),
- mindestens einem eine elektromagnetische Strahlung aussendenden Halbleiterchip (3), der in der Gehäusekavität (9) angeordnet ist, und
- einer für die Strahlung zumindest teilweise transparenten Abdeckung (4), die die Gehäusekavität (9) abdeckt, wobei
- die Abdeckung (4) derart mit dem Gehäuseunterteil (21) verbunden ist, dass die elektromagnetische Strahlung, die aus den Seitenflächen (11) der Abdeckung (4) austritt, absorbiert wird, wobei
- das Gehäuseunterteil (21) zumindest eine Gehäusebasis (1) und einen Gehäuserahmen (2) aufweist und der Gehäuserahmen (2) Ausnehmungen enthält, in denen die Abdeckung (4) eingebracht ist, und
- das Gehäuse ein Absorptionsmaterial (5) aufweist, das zwischen den Seitenflächen (11) der Abdeckung (4) und dem Gehäuserahmen (2) eingebracht ist und die zu den Seitenflächen (11) der Abdeckung (4) austretende Strahlung absorbiert,
**dadurch gekennzeichnet, dass**
- die Oberseite der Abdeckung (4), die entgegengesetzt zur Gehäusekavität (9) ausgebildet ist, im Randbereich mit einer absorbierenden Schicht (8) beschichtet ist.

2. Gehäuse nach Anspruch 1,
wobei die Höhe (h) der Abdeckung (4) gleich oder kleiner als die Höhe (H) der Rahmenausnehmung ist.

3. Gehäuse nach einem der vorherigen Ansprüche,
wobei das Absorptionsmaterial (5) ein absorbierendes Klebemittel ist, welches eine mechanische Verbindung zwischen der Abdeckung (4) und dem Gehäuseunterteil (21) vermittelt.

4. Gehäuse nach einem der Ansprüche 1 bis 3,
wobei die Seitenflächen (11) der Abdeckung (9)mit einer absorbierenden Schicht (5) beschichtet sind.

5. Gehäuse nach einem der vorhergehenden Ansprüche, wobei das Abdeckungsmaterial (4) ein Glas oder ein ausgehärtetes Silikon und thermisch resistent gegenüber der Strahlung des Halbleiterchips (3) ist.

6. Gehäuse nach einem der Ansprüche 1 bis 5,
wobei das Material des Gehäuserahmens (2) und der Gehäusebasis (1) ein Keramik oder Kunststoffmaterial thermisch resistent gegenüber der Strahlung des Halbleiterchips (3) ist.

7. Gehäuse nach Anspruch 1,
wobei das Material des Gehäuseunterteils (21) aus Aluminiumnitrid ist oder Aluminiumnitrid enthält.

8. Gehäuse nach einem der Ansprüche 1 bis 7,
wobei das Material des Gehäuserahmens (2) Aluminiumoxid ist und das Material der Gehäusebasis (1) Aluminiumnitrid ist.

## Claims

1. Housing with
- a lower housing part (21),
- a housing cavity (9) within the lower housing part (21)
- an opening of the housing cavity (9) formed on a housing side (10),
- at least one semiconductor chip (3) which emits an electromagnetic radiation and is arranged in the housing cavity (9), and
- a cover (4), which is at least partially transparent to the radiation and which covers the housing cavity (9), wherein
- the cover is connected to the lower housing part (21) in such a way that the electromagnetic radiation, which exits from the side surfaces (11) of the cover (4), wherein
- the lower housing part (21) has at least one housing base (1) and a housing frame (2) and the housing frame (2) contains recesses in which the cover (4) is introduced, and
- the housing has an absorption material (5), which is arranged between the side surfaces (11) of the cover (4) and the housing frame (2) and absorbs the radiation emerging from the side surfaces (11) of the cover (4),
**characterized in that**
- the top side of the cover (4), which is formed opposite to the housing cavity, is coated with an absorbent layer in the edge region.

2. Housing according to claim 1, wherein the height (h) of the cover (4) is equal to or less than the height (H) of the frame recess.

3. Housing according to one of the preceding claims,
wherein the absorption material (5) is an absorbent adhesive, which imparts a mechanical connection between the cover (4) and the lower housing part (21).

4. Housing according to one of claims 1 to 3,
wherein the side surfaces (11) of the cover (9) are coated with an absorbent layer (5).

5. Housing according to one of the preceding claims,
wherein the cover material (4) is a glass or a cured silicone and is thermally resistant to the radiation of the semiconductor chip (3).

6. Housing according to one of claims 1 to 5,
wherein the material of the housing frame and the housing base (1) a ceramic or plastic material is thermally resistant to the radiation of the semiconductor chip (3).

7. Housing according to claim 1,
wherein the material of the housing lower part (21) is made of aluminum nitride or contains aluminum nitride.

8. Housing according to one of claims 1 to 7,
wherein the material of the housing frame (2) is aluminum oxide and the material of the housing base (1) is aluminum nitride.

## Revendications

1. Boîtier comprenant
- une partie inférieure de boîtier (21),
- une cavité de boîtier (9) au sein de la partie inférieure du boîtier (21),
- une ouverture de la cavité du boîtier (9) formée sur un côté du boîtier (10),
- au moins une puce semi-conductrice (3) émettant un rayonnement électromagnétique et agencée dans la cavité du boîtier (9), et
- un couvercle (4) perméable au moins partiellement audit rayonnement, lequel couvercle recouvre la cavité du boîtier (9),
- ledit couvercle (4) étant relié à la partie inférieure du boîtier (21) de telle sorte que le rayonnement électromagnétique qui traverse les faces latérales (11) du couvercle (4) est absorbé,
- la partie inférieure du boîtier (21) présentant au moins un base de boîtier (1) et un cadre de boîtier (2), et ledit cadre du boîtier (2) contenant des évidements dans lesquels est placé le couvercle (4), et
- le boîtier présentant un matériau d'absorption (5) qui est placé entre les faces latérales (11) du couvercle (4) et le cadre du boîtier (2) et qui absorbe le rayonnement traversant les faces latérales (11) dudit couvercle (4),
**caractérisé en ce que**
- la face supérieure du couvercle (4) qui est formée à l'opposé de la cavité du boîtier (9) est revêtue en périphérie d'une couche absorbante (8).

2. Boîtier selon la revendication 1,
la hauteur (h) du couvercle (4) étant égale ou inférieure à la hauteur (H) de l'évidement du cadre.

3. Boîtier selon l'une quelconque des revendications précédentes,
le matériau d'absorption (5) étant un adhésif absorbant qui réalise une liaison mécanique entre le couvercle (4) et la partie inférieure du boîtier (21).

4. Boîtier selon l'une quelconque des revendications 1 à 3, les faces latérales (11) du couvercle (9) étant revêtues d'une couche absorbante (5).

5. Boîtier selon l'une quelconque des revendications précédentes, le matériau de couverture (4) étant un verre ou un silicone durci et résistant thermiquement au rayonnement de la puce semi-conductrice (3).

6. Boîtier selon l'une quelconque des revendications 1 à 5, le matériau du cadre du boîtier (2) et du base du boîtier (1) étant une céramique ou une matière plastique résistant thermiquement au rayonnement de la puce semi-conductrice (3) .

7. Boîtier selon la revendication 1,
le matériau de la partie inférieure du boîtier (21) étant en nitrure d'aluminium ou contenant du nitrure d'aluminium.

8. Boîtier selon l'une quelconque des revendications 1 à 7,
le matériau du cadre du boîtier (2) étant l'alumine et le matériau du base du boîtier (1) étant le nitrure d'aluminium.
